(19)

**Europäisches Patentamt**
**European Patent Office**
**Office européen des brevets**

(11) **EP 1 292 835 B1**

(12) **EUROPÄISCHE PATENTSCHRIFT**

(45) Veröffentlichungstag und Bekanntmachung des Hinweises auf die Patenterteilung:
**12.09.2007  Patentblatt 2007/37**

(51) Int Cl.:
*G01R 19/00* (2006.01)    *G01K 7/01* (2006.01)

(21) Anmeldenummer: **01951613.7**

(22) Anmeldetag: **20.06.2001**

(86) Internationale Anmeldenummer:
**PCT/EP2001/006972**

(87) Internationale Veröffentlichungsnummer:
**WO 2001/098790 (27.12.2001 Gazette 2001/52)**

(54) **VERFAHREN ZUR MESSUNG EINER SPANNUNG ODER EINER TEMPERATUR SOWIE ZUM ERZEUGEN EINER SPANNUNG MIT EINER BELIEBIG VORGEBBAREN TEMPERATURABHÄNGIGKEIT**

METHOD FOR MEASURING A VOLTAGE OR A TEMPERATURE AND FOR GENERATING A VOLTAGE WITH ANY PREDETERMINABLE TEMPERATURE DEPENDENCE

PROCEDE POUR MESURER UNE TENSION OU UNE TEMPERATURE ET POUR PRODUIRE UNE TENSION AVEC UNE DEPENDANCE PREDETERMINABLE DE LA TEMPERATURE

(84) Benannte Vertragsstaaten:
**AT BE CH CY DE DK ES FI FR GB GR IE IT LI LU MC NL PT SE TR**

(30) Priorität: **21.06.2000  DE 10029446**

(43) Veröffentlichungstag der Anmeldung:
**19.03.2003  Patentblatt 2003/12**

(73) Patentinhaber: **Braun GmbH**
**61476 Kronberg (DE)**

(72) Erfinder:
• **KLEMM, Torsten**
**65812 Bad Soden (DE)**
• **BERGK, Günther**
**65527 Niedernhausen (DE)**

(56) Entgegenhaltungen:
**US-A- 4 636 092        US-A- 6 008 685**

• **PATENT ABSTRACTS OF JAPAN vol. 018, no. 066 (E-1501), 3. Februar 1994 (1994-02-03) & JP 05 283749 A (CLARION CO LTD), 29. Oktober 1993 (1993-10-29)**

EP 1 292 835 B1

**Beschreibung**

Die Erfindung betrifft ein Verfahren und eine Schaltungsanordnung zur Messung einer Spannung und/oder einer Temperatur sowie zum Erzeugen einer Spannung mit einer beliebig vorgebbaren Temperaturabhängigkeit.

Aus der US 6,008,685 ist eine Schaltungsanordnung zur Messung einer Temperatur bekannt. Sie weist mehrere Stromquellen auf, die jeweils in ihrer absoluten Größe genau eingestellte Ströme liefern. Es werden die Spannungen an einem von diesen Strömen durchflossenen pn-Übergang gemessen und ausgewertet.

Aus der JP 05283749 A ist es bekannt, die Temperaturabhängigkeit der Durchlaßspannung eines von einem konstanten Strom durchflossenen pn-Übergangs zur Temperaturbestimmung auszunutzen.

Es ist Aufgabe der vorlegenden Erfindung ein einfaches Verfahren zur Messung einer Spannung und/oder einer Temperatur sowie zum Erzeugen einer Spannung mit beliebig vorgebbarer Temperaturabhängigkeit und eine besonders einfache Schaltungsanordnung zur Durchführung des Verfahrens anzugeben.

Die Lösung dieser Aufgabe erfolgt erfindungsgemäß durch ein Verfahren, das folgende Schritte aufweist: zuerst wird eine erste Flußspannung eines pn-Übergangs eines Halbleiterbauelements, beispielsweise einer Diode, gemessen, während er von einem ersten Strom durchflossen wird, und dann eine zweite Flußspannung desselben pn-Übergangs, während er von einem zweiten Strom durchflossen wird, wobei sich die Größe der beiden Ströme vorzugsweise um mehrere Zehnerpotenzen unterscheidet. Die beiden Messungen erfolgen vorzugsweise zeitlich unmittelbar hintereinander, damit bei beiden Messungen dieselben Meßbedingungen vorliegen, d.h. der pn-Übergang dieselbe Temperatur hat, und die Versorgungsspannung der zur Durchführung des Verfahrens verwendeten Schaltungsanordnung konstant ist. Anschließend wird mittels einer Rechenschaltung aus den Meßwerten und einem den pn-Übergang charakterisierenden Parameter ein der zu messenden Spannung proportionaler Wert bestimmt. Dieser Parameter ist durch das Verhältnis der Temperaturdriften der Flußspannungen beim ersten bzw. zweiten Strom gegeben. Er kann aus dem Kennlinienfeld des pn-Übergangs gewonnen werden.

Zur Berechnung der absoluten Größe der zu messenden Spannungen werden geeignete Proportionalitätsfaktoren benötigt. Zur Temperaturbestimmung muß die Rechenschaltung die Beziehung zwischen der Temperatur und der Flußspannung des pn-Übergangs bei zumindest einem Strom kennen. Diese Beziehung ist durch weitere den pn-Übergang charakterisierende Parameter beschrieben, die aus dem Kennlinienfeld des pn-Übergangs ermittelt werden können. Aus der berechneten Temperatur kann eine Spannung mit einer vorgegebenen Temperaturabhängigkeit berechnet werden. Die gewünschte Temperaturabhängigkeit ist durch weitere Parameter oder eine Funktion bestimmt.

Eine erfindungsgemäße Schaltungsanordnung weist einen A/D-Wandler, einen steuerbaren Schalter, ein Halbleiterbauelement mit einem pn-Übergang, beispielsweise eine Diode, eine Spannungsquelle, eine Rechenschaltung und eine Steuerschaltung für den steuerbaren Schalter und den A/D-Wandler auf. Durch den pn-Übergang kann ein Strom fließen, der von der Spannungsquelle geliefert und dessen Größe durch den steuerbaren Schalter zwischen zwei Werten hin- und hergeschaltet werden kann. Der A/D-Wandler tastet nach jedem Umschalten die am pn-Übergang auftretende Flußspannung ab, und liefert entsprechende digitale Meßwerte. Die Rechenschaltung kann aus den digitalen Meßwerten und den den pn-Übergang charakterisierenden Parametern einen der Flußspannung des pn-Übergangs proportionalen Wert, einen der Versorgungsspannung des A/D-Wandlers proportionalen Wert, bzw. erforderlichenfalls mittels geeigneter Proportionalitätsfaktoren auch deren absolute Größe, sowie die Temperatur des pn-Übergangs berechnen. Aus der Temperatur kann dann eine Spannung mit einer beliebig vorgebbaren Temperaturabhängigkeit berechnet und erforderlichenfalls in analoger oder digitaler Form ausgegeben werden. Die Parameter und die Proportionalitätsfaktoren sind vorzugsweise in der Rechenschaltung gespeichert. Die zur Bestimmung der Temperatur benötigte Beziehung zwischen der Flußspannung des pn-Übergangs beim gewählten Strom und der Temperatur des pn-Übergangs sowie die gewünschte Temperaturabhängigkeit der zu erzeugenden Spannung sind in an sich bekannter Weise, beispielsweise durch eine Tabelle oder als Formel, ebenfalls vorzugsweise in der Rechenschaltung oder einem Speicher gespeichert, auf den die Rechenschaltung zugreifen kann.

Mit dem erfindungsgemäßen Verfahren bzw. der erfindungsgemäßen Schaltungsanordnung läßt sich eine temperaturabhängige Spannung $U_{(T)}$ erzeugen, deren Temperaturabhängigkeit einstellbar ist. Eine solche Spannung kann beispielsweise zur Steuerung des Ent-/Ladevorgangs eines Akkumulators verwendet werden. Das erfindungsgemäße Verfahren bzw. die erfindungsgemäße Schaltungsanordnung kann aber auch zur Messung der Batterie- bzw. Akkuspannung und/oder Temperatur eines batterie- oder akkubetriebenen Geräts eingesetzt werden. Bei Geräten, die einen Mikrokontroller enthalten, hat die Erfindung den besonderen Vorteil, daß diese Messungen auch mit einem Mikrokontroller durchgeführt werden können, der keinen Referenzspannungsanschluß und auch keine interne Schaltung zur Erzeugung einer temperaturkompensierten Referenzspannung aufweist, und daher besonders preisgünstig ist.

Die Erfindung wird nachstehend anhand von Ausführungsbeispielen für erfindungsgemäße Schaltungsanordnungen erläutert, und die Ermittlung der beim erfindungsgemäßen Verfahren benötigten Parameter anhand eines Kennlinienfelds beschrieben. Es zeigen:

Fig. 1    schematisch eine erste erfindungsgemäße Schaltungsanordnung;

Fig. 2     schematisch eine zweite erfindungsgemäße Schaltungsanordnung;

Fig. 3     ein Kennlinienfeld eines pn-Übergangs eines Halbleiterbauelements;

Fig. 4     das Kennlinienfeld gemäß Figur 3 in anderer Darstellung.

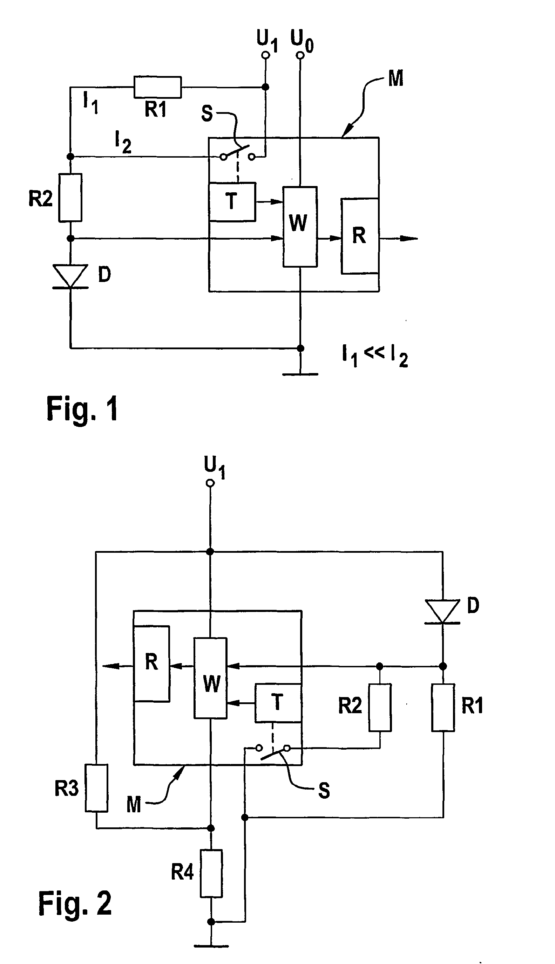

Die in Fig. 1 dargestellte erfindungsgemäße Schaltungsanordnung enthält einen A/D-Wandler W, der von einer Spannungsquelle mit einer Spannung $U_0$ versorgt ist, die auf Masse bezogen ist. Der Eingang des A/D-Wandlers W ist über einen in Flußrichtung geschalteten pn-Übergang eines Halbleiterbauelements, nämlich eine Diode D, mit Masse verbunden. Eine weitere Spannungsquelle mit der Spannung $U_1$ ist über einen ersten und einen zweiten Widerstand R1, R2 und über einen steuerbaren Schalter S und den zweiten Widerstand R2 mit dem Eingang des A/D-Wandlers W verbunden. Bei geöffnetem Schalter S kann ein erster Strom I1 über den ersten und zweiten Widerstand R1, R2, und bei geschlossenem Schalter S ein zweiter Strom I2 über den Schalter S und den zweiten Widerstand R2 durch die Diode D fließen. Der steuerbare Schalter S ist durch ein von einer Steuerschaltung T erzeugtes Taktsignal steuerbar, das auch dem A/D-Wandler W zugeführt ist. Der Ausgang des A/D-Wandlers W ist mit einer Rechenschaltung R verbunden, die einen analogen und/oder einen digitalen Ausgang aufweisen kann, an dem die gewünschte Spannung abgreifbar bzw. eine in der Figur nicht dargestellte Anzeigeeinrichtung anschließbar ist. Der steuerbare Schalter S, die Steuerschaltung T, die Rechenschaltung R und der A/D-Wandler W sind vorzugsweise in einem Mikrokontroller M integriert. Mit dieser Schaltungsanordnung kann eine erste Flußspannung der Diode D gemessen werden, während sie bei geöffnetem Schalter S von einem ersten Strom I1 durchflossen wird, und eine zweite Flußspannung derselben Diode D, während sie bei geschlossenem Schalter S von einem zweiten Strom I2 durchflossen wird, wobei sich die Größe der beiden Ströme I1, I2 vorzugsweise um mehrere Zehnerpotenzen unterscheidet. Die Spannungen $U_1$, $U_0$ der Spannungsquellen und die Widerstände R1, R2 sind so dimensioniert, daß sich einerseits die gewünschten Ströme I1 und I2 ergeben und andererseits die Spannung am Eingang des A/D-Wandlers W nie dessen Versorgungsspannung $U_0$ übersteigt.

Bei einer Variante der in Fig. 1 dargestellten erfindungsgemäßen Schaltungsanordnung sind die Spannungen $U_1$, $U_0$ der beiden Spannungsquellen gleich groß, d.h. es ist statt der zwei Spannungsquellen nur eine vorhanden. In diesem Fall muß der A/D-Wandler eine höhere Auflösung besitzen, wenn dieselbe Meßgenauigkeit erreicht werden soll wie bei der Schaltungsanordnung mit zwei Spannungsquellen.

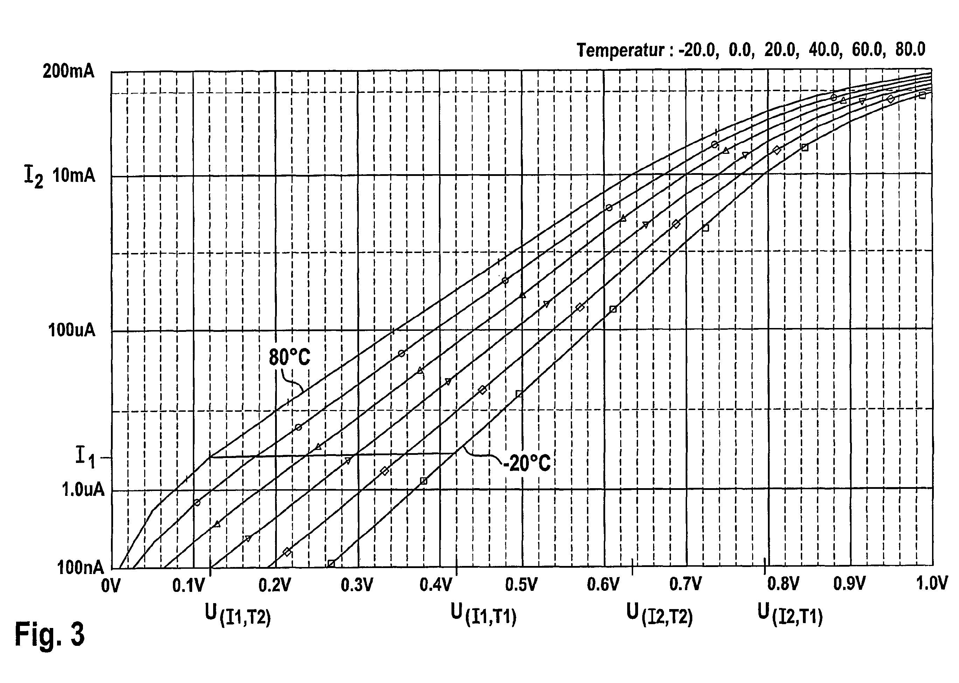

Zum erfindungsgemäßen Erzeugen einer Spannung mit beliebig einstellbarer Temperaturabhängigkeit, wird der Rechenschaltung zunächst die gewünschte Temperaturabhängigkeit als Funktion einprogrammiert oder in einem Speicher als Tabelle abgelegt. Vorzugsweise sind dort auch die Parameter gespeichert, die die Eigenschaften des verwendeten pn-Übergangs charakterisieren, und deren Ermittlung nachstehend anhand des in Figur 3 dargestellten Kennlinienfelds eines pn-Übergangs erläutert wird, das die Beziehung zwischen der Flußspannung des pn-Übergangs und dem durch den pn-Übergang fließenden Strom bei verschiedenen Temperaturen des pn-Übergangs in halblogarithmischer Darstellung wiedergibt. Bei dieser Darstellung ist die genannte Beziehung in einem großen Bereich linear.

Aus dem linearen Bereich des Kennlinienfelds werden für zwei verschieden gewählte Ströme I1, I2 bei zwei verschieden gewählten Temperaturen T1, T2 je eine Flußspannung $U_{(I, T)}$, d.h. insgesamt vier Flußspannungen $U_{(I1, T1)}$, $U_{(I1, T2)}$, $U_{(I2, T1)}$, $U_{(I2, T2)}$ entnommen. Die Temperaturdriften $\Delta U$ der Flußspannungen

$$\Delta U_{(I1)} = U_{(I1, T2)} - U_{(I1, T1)} \quad \text{und} \quad \Delta U_{(I2)} = U_{(I2, T2)} - U_{(I2, T1)} \tag{1}$$

unterscheiden sich, wie man anhand des Kennlinienfelds erkennt, bei den gewählten Strömen I1, I2 und Temperaturen T1, T2 um einen temperaturunabhängigen Faktor $n$, der einen ersten den pn-Übergang charakterisierenden Parameter darstellt:

$$n = \Delta U_{(I1)} / \Delta U_{(I2)} . \tag{2}$$

Durch Einsetzen von (1) und Umformen von (2) erhält man

$$n * U_{(I2, T2)} - U_{(I1, T2)} = n * U_{(I2, T1)} - U_{(I1, T1)} = k , \tag{3}$$

wobei $k$ eine temperaturunabhängige Konstante ist, die einen zweiten den pn-Übergang charakterisierenden Parameter darstellt. Wie man aus dem Kennlinienfeld erkennt, sind die Parameter n und *k* unabhängig davon, ob durch die Diode D der erfindungsgemäßen Schaltungsanordnung statt der gewählten Ströme I1, I2 beispielsweise aufgrund einer schwankenden Versorgungsspannung um einen bestimmten Faktor kleinere oder größere Ströme fließen. Allerdings sind *n* und *k* abhängig vom Verhältnis I1/I2. Kennlinienfelder anderer Halbleiterbauelemente, beispielsweise eines pn-Übergangs eines Transistors sind in gleicher Weise auswertbar.

Mit dem Parameter n kann die Rechenschaltung eine der Versorgungsspannung $U_0$ des A/D-Wandlers proportionale Größe bei beliebiger Temperatur des pn-Übergangs bestimmen oder eine der Temperatur des pn-Übergangs proportionale Größe bei beliebiger Versorgungsspannung $U_0$. Wird der Rechenschaltung zusätzlich noch eine bestimmte Temperaturfunktion eingegeben, kann sie eine Spannung mit der entsprechenden Temperaturabhängigkeit berechnen und erforderlichenfalls an einem ihrer Ausgänge in analoger oder digitaler Form ausgeben.

Zunächst wird die Bestimmung der Versorgungsspannung $U_0$ mit der in Fig. 1 dargestellten Schaltungsanordnung erläutert. Der A/D-Wandler liefert an seinem Ausgang einen Meßwert $M_{(T)}$, wenn an seinem Eingang eine Spannung $U_{(T)}$ anliegt (dabei wird vorausgesetzt, daß kein Überlauf des A/D-Wandlers auftritt):

$$M_{(T)} = M_{max} * U_{(T)} / U_0 \,, \qquad (4)$$

wobei $U_0$ die Versorgungsspannung des A/D-Wandlers und $M_{max}$ der größte durch den A/D-Wandler darstellbare Wert ist. Entsprechend gilt für die Eingangsspannungen $U_{(I1, T)}$, $U_{(I2, T)}$ und die zugehörigen Meßwerte $M1_{(T)}$, $M2_{(T)}$:

$$U_{(I1, T)} = M1_{(T)} * U_0 / M_{max} \quad \text{und} \quad U_{(I2, T)} = M2_{(T)} * U_0 / M_{max} \,. \qquad (5)$$

Setzt man (5) in (3) ein, folgt: $n * M2_{(T)} * U_0 / M_{max} - M1_{(T)} * U_0 / M_{max} = k$ , oder

$$U_0 = k * M_{max} / (n * M2_{(T)} - M1_{(T)}). \qquad (6)$$

Gleichung (6) besagt, daß die Versorgungsspannung $U_0$ der aus den Meßwerten M1, M2 bestimmten Größe $1/(n * M2_{(T)} - M1_{(T)})$ proportional ist, mit $k * M_{max}$ als Proportionalitätsfaktor. Die Bestimmung von $U_0$ ist unabhängig von der Temperatur des pn-Übergangs, weil $k/(n * M2_{(T)} - M1_{(T)})$ temperaturunabhängig ist (vgl. Gleichung 3).

Nachfolgend wird die Bestimmung der Temperatur T des pn-Übergangs mit der in Fig. 1 dargestellten Schaltungsanordnung erläutert. Setzt man (6) in (4) ein, folgt

$$U_{(T)} = k * M_{(T)} / (n * M2_{(T)} - M1_{(T)}), \qquad (7)$$

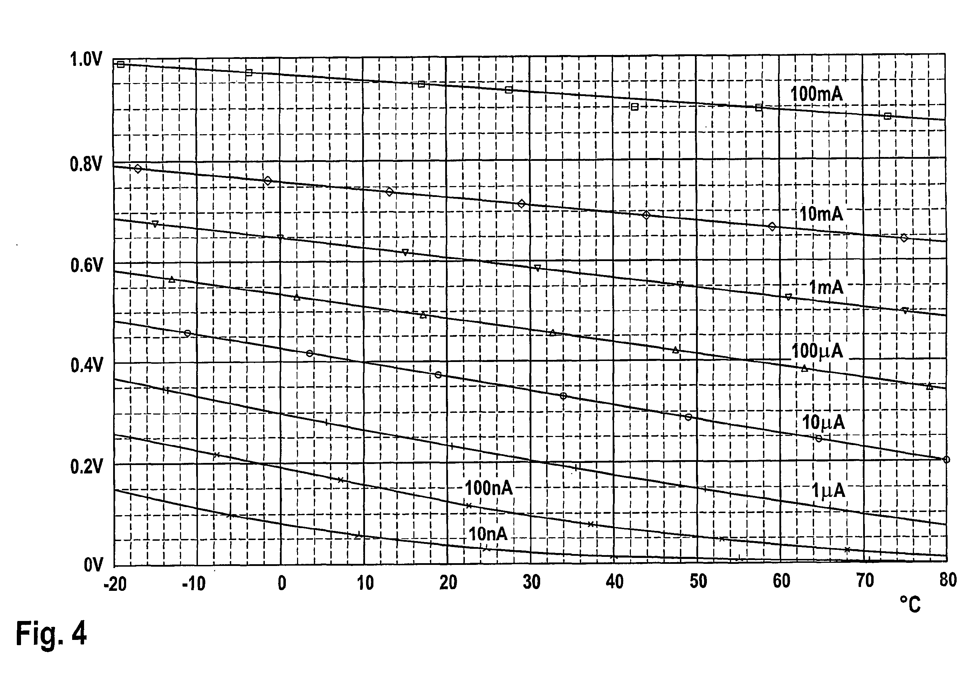

wobei die Temperaturabhängigkeit der Spannung $U_{(T)}$ durch die Eigenschaften des pn-Übergangs vorgegeben und in Fig. 4 dargestellt ist. Gemäß Fig. 4 ist die Beziehung zwischen der Temperatur T und der Flußspannung $U_{(I,T)}$ des pn-Übergangs weitgehend linear, d.h. die beim Strom I1 oder I2 gemessenen Flußspannungen $U_{(I1, T)}$ bzw. $_{(I2, T)}$ sind im linearen Bereich des Kennlinienfelds proportional zur Temperatur T. Folglich kann man nach Einsetzen von (6) in (5) schreiben

$$U_{(I1, T)} = k * M1_{(T)} / (n * M2_{(T)} - M1_{(T)}) = a_1 * T + b_1$$

und

$$U_{(I2, T)} = k * M2_{(T)} / (n * M2_{(T)} - M1_{(T)}) = a_2 * T + b_2 \qquad (8)$$

bzw.

$$U_{(I2)}/a_2 - b_2/a_2 = T_{(U)} = U_{(I1)}/a_1 - b_1/a_1. \tag{9}$$

Die Parameter $a_1$, $b_1$ oder $a_2$, $b_2$ können aus dem Kennlinienfeld des pn-Übergangs ermittelt werden, und sind vorzugsweise zusammen mit den Parametern $n$ und $k$ in der Rechenschaltung oder einem Speicher gespeichert, auf den die Rechenschaltung zugreifen kann. Zur Bestimmung der absoluten Größe der Temperatur T des pn-Übergangs wird also zunächst mit dem erfindungsgemäßen Verfahren die Flußspannung $U_{(I1, T)}$ oder $U_{(I2,T)}$ gemessen und dann die Temperatur T berechnet. Die Bestimmung der Temperatur T ist unabhängig von der Größe der Versorgungsspannung $U_0$.

Um eine Spannung $U_{(T)}$ zu erzeugen, die eine beliebige Temperaturabhängigkeit haben kann, muß die gewünschte Temperaturabhängigkeit der Spannung beispielsweise als Funktion $U_{(T)}$ in der Rechenschaltung programmiert oder als Tabelle in einem Speicher gespeichert sein, auf den die Rechenschaltung zugreifen kann. Vorzugsweise kann die Tabelle bzw. Programmierung über eine Eingabevorrichtung nach Belieben geändert werden. Nachdem die Temperatur mittels Gleichung (9) bestimmt wurde, kann die Spannung $U_{(T)}$ mit der entsprechenden Temperaturabhängigkeit von der Rechenschaltung berechnet und in analoger oder digitaler Form ausgegeben werden.

Soll beispielsweise eine Spannung $U_{(T)} = a*T+b$ mit vorgegebenen Parametern $a$, $b$ erzeugt werden, wird beispielsweise zunächst bei der Temperatur T' die Flußspannung $U_{(I2, T')}$ gemäß Gleichung (8) bestimmt. Die gewünschte Spannung $U_{(T')}$ ergibt sich dann mit Gleichung (9) zu: $U_{(T')} = U_{(I2, T')} *a/a_2 - b_2 *a/a_2 + b$.

Die in Figur 2 dargestellte erfindungsgemäße Schaltungsanordnung unterscheidet sich von der anhand von Figur 1 beschriebenen Schaltungsanordnung hauptsächlich dadurch, daß der Eingang des A/D-Wandlers W über die Diode D nicht mit Masse sondern mit der Spannungsquelle U1 verbunden ist, und daß der Eingang des A/D-Wandlers W über den ersten und zweiten Widerstand R1, R2 und den steuerbaren Schalter S nicht mit der Spannungsquelle sondern mit Masse verbunden ist. Allerdings sind der erste und zweite Widerstand R1, R2 nicht hintereinandergeschaltet, sondern der zweite Widerstand R2 ist mit dem steuerbaren Schalter S hintereinandergeschaltet. Parallel dazu liegt der erste Widerstand R1. Daher fließt bei geöffnetem Schalter S der erste Strom I1 über den ersten Widerstand R1, und bei geschlossenem Schalter S der zweite Strom I2 über beide Widerstände R1, R2 und den Schalter S durch die Diode D. Ferner ist nur eine Spannungsquelle U1 vorhanden, die über einen aus einem dritten und vierten Widerstand R3, R4 gebildeten Spannungsteiler die Versorgungsspannung $U_0$ des A/D-Wandlers liefert.

Bei einer Variante der in Fig. 2 dargestellten erfindungsgemäßen Schaltungsanordnung fehlen der dritte und vierte Widerstand R3, R4, d.h. der A/D-Wandler liegt zwischen der Spannungsquelle U1 und Masse. In diesem Fall muß der A/D-Wandler eine höhere Auflösung besitzen, wenn dieselbe Meßgenauigkeit erreicht werden soll wie bei der in Fig. 2 dargestellten erfindungsgemäßen Schaltungsanordnung.

Die Berechnung der mit der in Fig. 2 dargestellten Schaltungsanordnung zu messenden Versorgungsspannung $U_0$ des A/D-Wandlers W und/oder der Temperatur T der Diode D wird nachfolgend erläutert. Der A/D-Wandler W liefert an seinem Ausgang einen Meßwert $M$, wenn an der Diode D die Spannung $U$ abfällt, und daher am Eingang des A/D-Wandlers W eine Spannung $U_0-U$ anliegt (dabei wird vorausgesetzt, daß die Flußspannung $U$ der Diode D nie größer als die Versorgungsspannung $U_0$ des A/D-Wandlers ist):

$$M = M_{max} * (U_0 - U) / U_0 , \tag{4'}$$

wobei $U_0$ die Versorgungsspannung des A/D-Wandlers und $M_{max}$ der größte durch den A/D-Wandler darstellbare Wert ist. Entsprechend gilt für die Eingangsspannungen $U_{(I1)}$, $U_{(I2)}$ und die zugehörigen Meßwerte $M1$, $M2$:

$$U_{(I1)} = U_0 - M1*U_0 / M_{max} \quad \text{und} \quad U_{(I2)} = U_0 - M2*U_0 / M_{max} . \tag{5'}$$

Setzt man (5') in (3) ein, folgt:

$$U_0 = k*M_{max} / (n(M_{max} - M2) - (M_{max} - M1)). \tag{6'}$$

Setzt man (6') in (5') ein, folgt für die Flußspannungen $U_{(I1)}$ und $U_{(I2)}$ beim Strom I1 bzw. I2:

$$U_{(I1)} = k*(M_{max} - M1) / (n(M_{max} - M2) - (M_{max} - M1))$$

und $\qquad\qquad\qquad\qquad\qquad\qquad\qquad\qquad\qquad\qquad\qquad$ (8')

$$U_{(I2)} = k*(M_{max} - M2) / (n(M_{max} - M2) - (M_{max} - M1))$$

Ein Vergleich der Beziehungen (6'), (8') mit den Beziehungen (6), (8) zeigt, daß die Berechnung der zu messenden Spannungen bei der Schaltungsanordnung gemäß Fig. 2 genau so erfolgt wie bei der Schaltungsanordnung gemäß Fig. 1, jedoch sind die Meßwerte *M1, M2* durch *($M_{max}$ - M1)* bzw. *($M_{max}$ - M2)* zu ersetzen.

**Patentansprüche**

1. Verfahren zur Messung einer Spannung ($U_0$) mit Hilfe eines A/D-Wandlers (W),
   **gekennzeichnet durch** folgende Schritte,
   Anlegen der zu messenden Spannung ($U_0$) an die Versorgungsspannungsanschlüsse des A/D-Wandlers (W),
   Ermitteln eines ersten Meßwerts M1 für eine erste Flußspannung $U_{(I1,T)}$ eines von einem ersten Strom (I1) durchflossenen pn-Übergangs eines Halbleiterbauelements, Ermitteln eines zweiten Meßwerts (M2) für eine zweite Flußspannung $U_{(I2,T)}$ desselben aber von einem zweiten Strom (I2) durchflossenen pn-Übergangs,
   Berechnen eines der zu messenden Spannung ($U_0$) proportionalen Werts

$$M_{max} / (n*M2 - M1) \quad \text{oder} \quad M_{max} / (n(M_{max} - M2) - (M_{max} - M1))$$

   aus den mit Hilfe des A/D-Wandlers (W) ermittelten Meßwerten (M1, M2) und einem den pn-Übergang charakterisierenden Parameter n, wobei der Parameter n das Verhältnis der Temperaturdriften ($\Delta U_{(I1)}$, $\Delta U_{(I2)}$) der Flußspannungen bei den gewählten Strömen (I1, I2) darstellt, d.h. $n=(U_{(I1,T2)} - U_{(I1,T1)}) / (U_{(I2,T2)} - U_{(I2,T1)})$, und wobei der Parameter $M_{max}$ der größte vom A/D-Wandler (W) darstellbare Meßwert ist.

2. Verfahren nach Anspruch 1,
   **gekennzeichnet durch** folgende Schritte,
   Berechnen der zu messenden Spannung ($U_0$) aus dem proportionalen Wert und einem Proportionalitätsfaktor *(k)*,
   $k = n*U_{(I2,T2)} - U_{(I1,T2)} = n*U_{(I2,T1)} - U_{(I1,T1)}$.

3. Verfahren zur Messung einer ersten oder zweiten Flußspannung $U_{(I1,T)}$ ; $U_{(I2,T)}$) eines pn-Übergangs mit Hilfe eines A/D-Wandlers (W),
   **gekennzeichnet durch** folgende Schritte,
   Ermitteln eines ersten Meßwerts M1 für eine erste Flußspannung $U_{(I1,T)}$ eines von einem ersten Strom (I1) durchflossenen pn-Übergangs eines Halbleiterbauelements, Ermitteln eines zweiten Meßwerts M2 für eine zweite Flußspannung $U_{(I2,T)}$ desselben aber von einem zweiten Strom (I2) durchflossenen pn-Übergangs,
   Berechnen eines der zu messenden ersten Flußspannung $U_{(I1,T)}$ proportionalen ersten Werts *M1/(n*M2 - M1)* oder *($M_{max}$ - M1)/(n($M_{max}$ - M2) - ($M_{max}$ - M1))* aus den mit Hilfe des A/D-Wandlers (W) ermittelten Meßwerten M1, M2 und einem den pn-Übergang charakterisierenden Parameter n, oder
   Berechnen eines der zu messenden zweiten Flußspannung $U_{(I2,T)}$ proportionalen zweiten Werts *M2/(n*M2 - M1)* oder *($M_{max}$ - M2)/(n($M_{max}$ - M2) - ($M_{max}$ - M1))* aus den mit Hilfe des A/D-Wandlers (W) ermittelten Meßwerten M1, M2 und einem den pn-Übergang charakterisierenden Parameter n,
   wobei der Parameter n das Verhältnis der Temperaturdriften ($\Delta U_{(I1)}$, $\Delta U_{(I2)}$) der Flußspannungen bei den gewählten Strömen (I1, I2) darstellt, d.h.
   $n=(U_{(I1, T2)} - U_{(I1, T1)}) / (U_{(I2, T2)} - U_{(I2, T1)})$, und wobei der Parameter $M_{max}$ der größte vom A/D-Wandler (W) darstellbare Meßwert ist.

4. Verfahren nach Anspruch 3,
   **gekennzeichnet durch** folgende Schritte,
   Berechnen der zu messenden ersten oder zweiten Flußspannung $U_{(I1,T)}$ ; $U_{(I2,T)}$ aus dem ersten bzw. zweiten proportionalen Wert und einem Proportionalitätsfaktor k, wobei $k = n*U_{(I2,T2)} - U_{(I1,T2)} = n*U_{(I2,T1)} - U_{(I1,T1)}$.

5. Verfahren nach einem der vorhergehenden Ansprüche,
**dadurch gekennzeichnet,**
**daß** die beiden Ströme (I1, I2) vorzugsweise um mehrere Zehnerpotenzen unterschiedlich groß gewählt sind.

6. Verfahren zur Messung einer Temperatur,
**gekennzeichnet durch folgende Schritte,**
Messen einer Flußspannung $U_{(I,T)}$ eines pn-Übergangs eines Halbleiterbauelements bei einem vorgegebenen Strom (I) mittels des Verfahrens zur Messung einer Flußspannung nach einem der Ansprüche 3 bis 5, und
Berechnen der Temperatur (T) des pn-Übergangs aus der gemessenen Flußspannung $U_{(I,T)}$ und einer zuvor ermittelten Beziehung zwischen der Temperatur und der Flußspannung $U_{(I,T)}$ des pn-Übergangs beim vorgegebenen Strom (I).

7. Verfahren zum Erzeugen einer Spannung mit vorgebbarer Temperaturabhängigkeit,
**gekennzeichnet durch** folgende Schritte,
Ermitteln der Temperatur eines pn-Übergangs eines Halbleiterbauelements nach Anspruch 6,
Berechnen der Spannung mit der vorgegebenen Temperaturabhängigkeit aus der ermittelten Temperatur und der vorgegebenen Temperaturabhängigkeit,
Ausgeben der berechneten Spannung in analoger oder digitaler Form.

## Claims

1. A method for measuring a voltage ($U_0$) with the aid of an A/D converter (W),
**characterized by** the following steps
applying the voltage ($U_0$) to be measured to the supply voltage terminals of the A/D converter (W),
determining a first measured value M1 for a first forward voltage $U_{(I1, T)}$ of a pn-junction of a semiconductor component, through which a first current (I1) flows,
determining a second measured value (M2) for a second forward voltage $U_{(I2, T)}$ of the same pn-junction, but through which a second current (I2) flows,
calculating a value $M_{max} / (n*M2 - M1)$ or $M_{max} /(n(M_{max} - M2) - (M_{max} - M1))$ that is proportional to the voltage ($U_0$) to be measured from the measured values (M1, M2) determined with the aid of the A/D converter (W) and a parameter n that characterizes the pn-junction, wherein the parameter n represents the ratio between the temperature drifts ($\Delta U_{(I1)}$, $\Delta U_{(I2)}$) of the forward voltages at the chosen currents (I1, I2), i.e., $n = (U_{(I1, T2)} - U_{(I1, T1)}) / (U_{(I2, T2)} - U_{(I2, T1)})$, and wherein the parameter $M_{max}$ is the greatest measured value educible by the A/D converter (W).

2. The method according to Claim 1,
**characterized by** the following steps
calculating the voltage ($U_0$) to be measured from the proportional value and a proportionality factor (k), $k = n*U_{(I2, T2)} - U_{(I1, T2)} = n*U_{(I2, T1)} - U_{(I1, T1)}$.

3. A method for measuring a first or second forward voltage $U_{(I1, T)}$, $U_{(I2, T)}$ of a pn-junction with the aid of an A/D converter (W),
**characterized by** the following steps
determining a first measured value M1 for a first forward voltage $U_{(I1, T)}$ of a pn-junction of a semiconductor component, through which a first current (I1) flows,
determining a second measured value M2 for a second forward voltage $U_{(I2, T)}$ of the same pn-junction, but through which a second current (I2) flows,
calculating a first value $M1 / (n*M2 - M1)$ or $(M_{max} - M1) / (n (M_{max} - M2) - (M_{max} - M1))$ that is proportional to the first forward voltage $U_{(I1, T)}$ to be measured from the measured values M1, M2 determined with the aid of the A/D converter (W) and a parameter n that characterizes the pn-junction or
calculating a second value $M2 / (n*M2 - M1)$ or $(M_{max} - M_2) / (n (M_{max} - M2) - (M_{max} - M1))$ that is proportional to the second forward voltage $U_{(I2, T)}$ to be measured from the measured values M1, M2 determined with the aid of the A/D converter (W) and a parameter n that characterizes the pn-junction,
wherein the parameter n represents the ratio between the temperature drifts ($\Delta U_{(I1)}$, $\Delta U_{(I2)}$) of the forward voltages at the chosen currents (I1, I2), i.e., $n = (U_{(I1, T2)} - U_{(I1, T1)}) / (U_{(I2, T2)} - U_{(I2, T1)})$, and wherein the parameter $M_{max}$ is the greatest measured value educible by the A/D converter (W).

4. The method according to Claim 3,
**characterized by** the following steps
calculating the first or second forward voltage $U_{(I1, T)}$; $U_{(I2, T)}$ to be measured from the first or second proportional value and a proportionality factor k, wherein $k = n*U_{(I2, T2)} - U_{(I1, T2)} = n*U_{(I2, T1)} - U_{(I1, T1)}$ .

5. The method according to one of the preceding claims,
**characterized in**
**that** the intensities of the two currents (I1, I2) are preferably chosen such that they differ by several powers of ten.

6. A method for measuring a temperature,
**characterized by** the following steps
measuring a forward voltage $U_{(I, T)}$ of a pn-junction of a semiconductor component at a given current (I) by means of the method for measuring a forward voltage according to one of Claims 3 to 5, and
calculating the temperature (T) of the pn-junction from the measured forward voltage $U_{(I, T)}$ and a previously determined relation between the temperature and the forward voltage $U_{(I, T)}$ of the pn-junction at the given current (I).

7. A method for generating a voltage with predetermined temperature dependence,
**characterized by** the following steps
determining the temperature of a pn-junction of a semiconductor component in accordance with Claim 6,
calculating the voltage with the predetermined temperature dependence from the determined temperature and the predetermined temperature dependence, and
outputting the calculated voltage in analog or digital form.

## Revendications

1. Procédé pour mesurer une tension ($U_0$) à l'aide d'un transformateur A/D (W),
**caractérisé par** les étapes suivantes :

Application de la tension à mesurer ($U_0$) aux branchements de tension d'alimentation du transformateur A/D (W),
Détermination d'une première valeur de mesure M1 pour une première tension d'écoulement $U_{(I1,T)}$ d'une jonction-pn traversée par un premier courant (I1) d'un composant à semi-conducteur,
Détermination d'une deuxième valeur de mesure (M2) pour une deuxième tension d'écoulement $U_{(I2,T)}$ de la même jonction-pn, traversée toutefois par un deuxième courant (M2),
Calcul d'une valeur proportionnelle à la tension à mesurer ($U_0$) $M_{max}/(n*M2 - M1)$ ou $M_{max}/ (n(M_{max} - M2) - (M_{max} - M1))$ à partir des valeurs de mesure (M1, M2) déterminées à l'aide du transformateur A/D (W) et d'un paramètre n caractérisant la jonction-pn, le paramètre n représentant la relation des dérives de température ($\Delta U_{(I1)}$, $\Delta U_{(I2)}$ des tensions d'écoulement, avec les courants choisis (I1, I2) c'est-à-dire que $n=(U_{(I1, T2)} - U_{(I1, T1)}) / (U_{(I2, T2)} - U_{(I2/T1)})$ et le paramètre $M_{max}$ étant la plus grande valeur pouvant être obtenue par le transformateur A/D (W).

2. Procédé selon la revendication 1,
**caractérisé par** les étapes suivantes :

Calcul de la tension à mesurer ($U_0$) à partir de la valeur proportionnelle et d'un facteur de proportionnalité (k), $k$ étant $= n*U_{(I2, T2)} - U_{(I1, T2)} = n*U_{(I2, T1)} - U_{(I1, T1)}$

3. Procédé pour mesurer une première ou une deuxième tension d'écoulement $U_{(I1, T)}$ ; $U_{(I2,T)}$ d'une jonction-pn, à l'aide d'un transformateur A/D (W),
**caractérisé par** les étapes suivantes :

Détermination d'une première valeur de mesure M1 pour une première tension d'écoulement $U_{(I1, T)}$ d'une jonction-pn traversée par un premier courant (I1) d'un composant à semi-conducteur, Détermination d'une deuxième valeur mesurée (M2) pour une deuxième tension d'écoulement $U_{(I2,T)}$ de la même jonction-pn, traversée toutefois par un deuxième courant (M2),
Calcul d'une première valeur M1/n*M2-M1) ou (Mmax - M1) / (n (Mmax - M2) - (Mmax - M1), à partir des valeurs de mesure (M1, M2) déterminées à l'aide du transformateur A/D (W) et d'un paramètre n caractérisant la jonction-pn, ou

Calcul d'une deuxième valeur $M2/(n*M2 - M1)$ ou $(M_{max} - M2) / (n (M_{max} - M2) - (M_{max} - M1))$ proportionnelle à la deuxième tension $U_{(I2,T)}$ d'écoulement à mesurer à partir des valeurs de mesure M1, M2 déterminées à l'aide du transformateur A/D (W) et d'un paramètre caractérisant la jonction-pn,
le paramètre n représentant la relation des dérives de température ($\Delta U(I1)$, $\Delta U(I2)$) des tensions d'écoulement, avec les courants choisis (I1, I2), c'est-à-dire que c'est-à-dire que $n= (U_{(I1, T2)} - U_{(I1,T1)})/ (U_{(I2,T2)} - U_{(I2/T1)})$ et le paramètre $M_{max}$ étant la plus grande valeur pouvant être obtenue par le transformateur A/D (W)4.

4. Procédé selon la revendication 3,
   **caractérisé par** les étapes suivantes,
   Calcul de la première ou de la deuxième tension d'écoulement à mesurer U (I1,T) ; U(I2,T), à partir de la première ou de la deuxième valeur proportionnelle et d'un facteur de proportionnalité k, $k = n*U_{(I2,T2)} - U_{(I1,T2)} = n*U_{(I2,T1)} - U_{(I1, T1)}$

5. Procédé selon l'une quelconque des revendications précédentes,
   **caractérisé en ce que**,
   les deux courants (11, 12) sont choisis de préférence avec un valeur différant de plusieurs puissances de dix.

6. Procédé pour mesurer une température,
   **caractérisé par** les étapes suivantes,
   Mesure d'une tension d'écoulement $U_{(I, T)}$ d'une jonction-pn d'un composant à semi-conducteur avec un courant prédéterminé (I) au moyen du procédé pour mesurer une tension d'écoulement selon l'une quelconque des revendications 3 à 5, et
   Calcul de la température (T) de la jonction-pn à partir de la tension d'écoulement mesurée $U_{(I,T)}$ et d'une relation précédemment déterminée entre la température et la tension d'écoulement $U_{(I, T)}$ de la jonction-pn au courant prédéterminé (I).

7. Procédé pour la production d'une tension avec une dépendance prédéterminable de la température,
   **caractérisé par** les étapes suivantes,
   Détermination de la température d'une jonction-pn d'un composant à semi-conducteur selon la revendication 6,
   Calcul de la tension avec la dépendance prédéterminable de la température, à partir de la température déterminée et de la dépendance prédéterminée de la température, édition de la tension calculée sous forme analogique ou numérique.

**Fig. 1**

$I_1 \ll I_2$

**Fig. 2**

Fig. 3

Fig. 4

EP 1 292 835 B1

**EP 1 292 835 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6008685 A

- JP 05283749 A